# EUROPEAN PATENT APPLICATION

(11) **EP 4 701 017 A1**
(43) Date of publication of application: **25.02.2026**
(21) Application number: 25191799.3
(22) Date of filing: 25.07.2025
(51) Int. Cl.: H02H 3/32, H02H 3/16

(54) **SYSTEMS, CONTROLLERS, AND METHODS FOR FAULT DETECTION**

(30) Priority: 08.08.2024 US 202418798789
(71) Applicant: Cummins Power Generation, Inc., Minneapolis MN 55432 (US)
(72) Inventor: Moe, Justin, Forest Lake, 55025 (US); Verma, Shubhranshu, Plymouth, 55446 (US)
(74) Representative: Cleveland Scott York

(57) **Abstract**

Fault detection is provided. A system for fault detection includes an earthing transformer (106) structured to be coupled with an alternating current (AC) output of an inverter (104) and an earthing device (112). The system includes a controller (110). The controller is configured to receive a voltage for multiple phases of an output, or the input voltages with respect to ground of the inverter. The controller is configured to determine a difference between a first voltage of the voltages and a second voltage of the voltages. The controller is configured to compare the determined difference to a predefined threshold. The controller is configured to classify, based on the comparison, a first fault state of a circuit comprising the inverter.

## Description

### BACKGROUND

The present disclosure relates generally to fault detection (e.g., ground fault detection). A ground fault can form between any of various phases of an alternating current (AC) circuit or direct current (DC) circuit.

### SUMMARY

Some embodiments relate to a system for fault detection. The system includes an earthing transformer structured to be coupled with an alternating current (AC) output of an inverter, an earthing device, and a controller. The controller is configured to receive a voltage for each of multiple phases of an output of the inverter. The controller is configured to determine a difference between a first voltage of the voltages and a second voltage of the voltages. The controller is configured to compare the determined difference to a predefined threshold. The controller is configured to classify, based on the comparison, a first fault state of a circuit including the inverter.

In some embodiments, the controller is configured to classify each of a first fault state, a second fault state, and a third fault state. The first fault state corresponds to a ground fault between a first phase of the output of the inverter and a ground reference. The second fault state corresponds to a ground fault between a second phase of the output of the inverter and the ground reference. The third fault state corresponds to a ground fault between the third phase of the output of the inverter and the ground reference. In some embodiments, the controller is configured to classify a state corresponding to an absence of a fault between a phase of the output of the inverter and the ground reference.

In some embodiments, the controller is configured to receive an indication of a third voltage at a first direct current (DC) input to the inverter. The controller can receive an indication of a fourth voltage at a second DC input to the inverter. The controller can classify, based on a comparison of the third voltage to the fourth voltage, a second fault state of the circuit comprising the inverter. In some embodiments, the controller is configured to generate a control signal responsive to the detection of a fault state, the control signal to cause a decoupling between the inverter and a grid forming energy source. In some embodiments, the controller is configured to generate the control signal responsive to multiple faults. In some embodiments, the controller is configured to generate the control signal responsive to a single fault. In some embodiments, the controller is configured to detect the first fault state for each of multiple inverters.

In some embodiments, the controller is configured to receive, from the inverter, an indication of an inverter status. The controller can generate, responsive to the receipt of the indication, a control signal to effect a decoupling of the inverter from a power source. In some embodiments, the controller is configured to communicate the control signal to a switch to actuate the switch to decouple the inverter from an AC circuit at the output of the inverter. In some embodiments, the controller is configured to communicate the control signal to the inverter to decouple the inverter from a DC circuit at an input of the inverter.

Some embodiments relate to a controller for fault detection. The controller includes one or more processing circuits. The controller is configured to receive, from a sensor coupled with an earthing transformer, an indication of a voltage of each of multiple phases of an alternative current (AC) signal of an inverter. The controller is configured to determine a first voltage between two of the phases. The controller is configured to determine a presence of a ground fault based on the first voltage. The controller is configured to generate a control signal to decouple an energy source from the inverter responsive to the presence of the ground fault.

In some embodiments, the controller is configured to determine the presence of the ground fault by comparing the first voltage to a predefined threshold. In some embodiments, the sensor includes a first potential transformer coupled with a first phase of an output of the inverter, a second potential transformer coupled with a second phase of the output of the inverter, and a third potential transformer coupled with a third phase of the output of the inverter. For example, the potential transformers may be coupled with the earthing transformer. The controller can receive signals from at least two of the first potential transformer, the second potential transformer, and the third potential transformer. For example, the controller can receive a signal from each of the first and second PT, the first and third, PT, or the second and third PT. The controller can determine the first voltage based on the received signals.

In some embodiments, the controller is configured to receive, from a direct current (DC) input to the inverter, an indication of an input voltage. The controller can compare the DC input to a predefined threshold. The controller can interrupt a connection, responsive to the comparison, between the DC input and the inverter or the inverter and an AC circuit at an output of the inverter.

In some embodiments, the input voltage is received from a battery having an anode voltage exceeding a ground voltage by a first magnitude, the ground voltage exceeding a cathode voltage by the first magnitude. In some embodiments, the controller is configured to compare the DC input by summing the cathode voltage and the anode voltage and comparing a magnitude of the summation to a predefined threshold voltage.

In some embodiments, the controller is configured to receive, from the inverter, an indication of inverter status. The controller can couple, responsive to the indication of inverter status, the inverter with an AC circuit at an output of the inverter.

Some embodiments relate to a method for power delivery. The method includes receiving, from a sensor coupled with a multi-phase earthing transformer and by a controller, an indication of a power signal for each phase of the multi-phase earthing transformer. The method includes comparing, by the controller, a magnitude of the power signal between two of the phases. The method includes determining, by the controller, a ground fault condition based on the comparison. The method includes halting, by the controller, the operation of an inverter based on the determination.

In some embodiments, the method includes receiving, from a potential transformer, the power signal. In some embodiments, halting the operation includes sending, by the controller to a second controller of the inverter, an instruction to halt operation. In some embodiments, the halting the operation includes actuating, by the controller, a switch electrically coupled with an isolation transformer having a first winding electrically coupled with an output of the inverter and a second winding electrically coupled with an AC circuit at the output of the inverter.

This summary is illustrative only and is not intended to be in any way limiting. Other aspects, inventive features, and advantages of the devices or processes described herein will become apparent in the detailed description set forth herein, taken in conjunction with the accompanying figures, wherein like reference numerals refer to like elements.

### BRIEF DESCRIPTION OF THE FIGURES

FIG. 1 is a block diagram of an example fault detection system for a power distribution network, according to some embodiments.
FIG. 2 is a block diagram of another example fault detection system for a power distribution network, according to some embodiments.
FIG. 3 depicts a voltage of various phases of an inverter output, as referenced to an earthing device coupled with an earthing transformer, according to some embodiments.
FIG. 4 depicts a difference between the phases of FIG. 3, according to some embodiments.
FIG. 5 depicts a sum of first and second DC inputs undergoing a ground fault, according to some embodiments.
FIG. 6 is a flow diagram for a method of fault detection, according to some embodiments.
FIG. 7 is a block diagram illustrating an architecture for a computer system that can be employed to implement elements of the systems and methods described and illustrated herein.

### DETAILED DESCRIPTION

Following below are more detailed descriptions of various concepts related to, and implementations of, systems, controllers, and methods for fault detection (e.g., ground fault detection). Before turning to the figures, which illustrate certain exemplary embodiments in detail, it should be understood that the present disclosure is not limited to the details or methodology set forth in the description or illustrated in the figures. It should also be understood that the terminology used herein is for the purpose of description only and should not be regarded as limiting.

Referring to the figures generally, the various embodiments disclosed herein relate to systems and devices of ground fault detection, and methods of their use. Ground faults can develop between phases of an inverter or other electrical device. For example, a three-phase inverter can receive a DC source and activate switches (e.g., transistors, relays, or thyristors) to generate a first phase, second phase, and third phase. Any of the phases may become electrically coupled with a ground. For example, where insulation for a conductive cable, bus bar, or other signal carrier becomes abraded or degrades over time, the conductive signal carrier can come in contact with a chassis, earth ground, etc. Likewise, ground faults can arise from mechanical impacts, accumulation of dust or moisture, or failure of electrical components (e.g., diodes within the inverter). A ground fault can form between any of the phases of an AC circuit (e.g., inverter output) or DC circuit (e.g., inverter input). Ground faults can form at one point or multiple points in a circuit. In some instances (as is more often observed in single faults), ground currents can be relatively low, and a device can continue operation under such a fault condition. In some instances, device operation can be interrupted responsive to any fault condition.

It may be challenging to detect ground faults in some device configurations. For example, many AC circuits include a delta configuration lacking a neutral wire, so that no reference voltage is physically available for comparison to AC phases. Moreover, a voltage level associated with such a neutral (sometimes referred to as a "virtual neutral" or "phantom neutral") can float relative to a chassis or earth ground, compounding difficulty in determining a leakage path between a phase and a ground which may differ from the virtual neutral. An earthing transformer can provide a neutral point for an AC signal (e.g., a delta configuration). For example, an earthing transformer can provide a neutral point with reference to a ground (e.g., earth ground) by providing a low impedance path for neutral current to flow to ground. The earthing transformer can be implemented as a zigzag earthing transformer or delta-wye configuration.

A controller can receive, from the sensors, signal values for each of the phases, and make a comparison therebetween. For example, the controller can determine a difference between a voltage of one phase from another phase. The controller can compare the difference to a threshold (e.g., a threshold of near zero volts) to detect the ground fault. In some embodiments, the controller can further detect DC ground faults by comparing voltages of a battery or other DC source without a ground reference. In some embodiments, the controller is configured to halt circuit operation upon a detection of one or more ground faults. For example, the controller can actuate a circuit breaker or other disconnect, or cause an inverter or battery to halt operation according to a communication therewith.

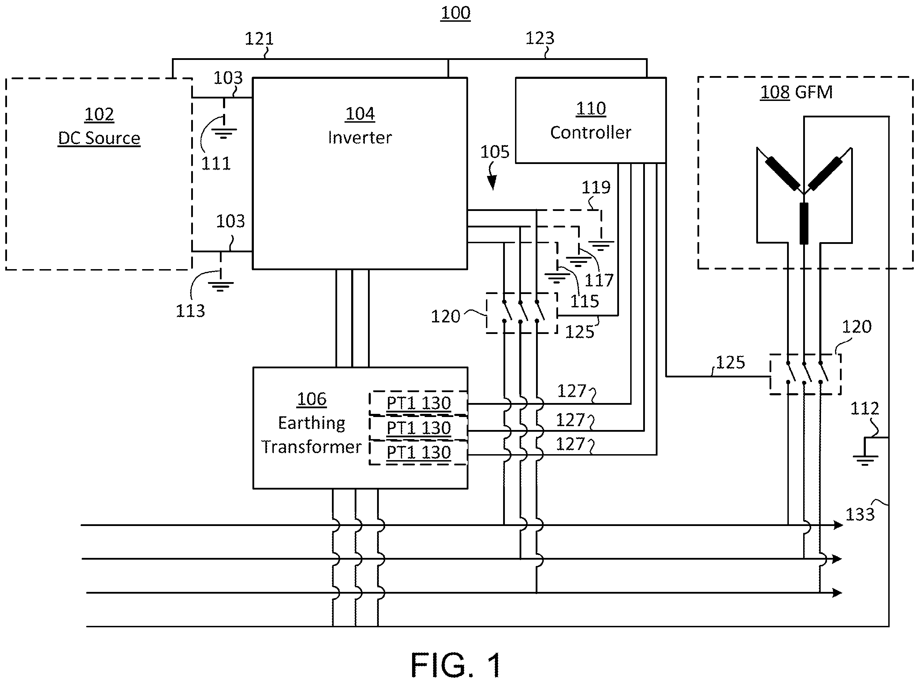

As shown in FIG. 1, a system 100 for fault detection includes an earthing transformer 106 structured to be coupled with an alternating current (AC) output 105 of an inverter 104 and an earthing device 112. The system includes a controller 110. The controller 110 is configured to receive a voltage for each of multiple phases of an output 105 of the inverter 104. For example, the controller 110 can communicatively couple with the one or more sensors 130 to receive the voltage therefrom. The controller 110 is configured to determine a difference between a first voltage of the multiple voltages and a second voltage of the multiple voltages. The controller 110 is configured to compare the determined difference to a predefined threshold. The controller 110 is configured to classify, based on the comparison, a first fault state of a circuit comprising the inverter 104.

The inverter 104 can receive a direct current (DC) input from a DC source 102. For example, the DC source can include a battery, fuel cell, supercapacitor, other DC source 102. The DC source 102 can output a first and second voltage. For example, an 800-volt battery system can couple with the inverter 104 via a first DC input 103 at 400-volts greater than a ground reference, and a second DC input 103 at 400-volts less than the ground reference. The ground reference can refer to a voltage measured at an earthing device 112 proximal to the earthing transformer 106. For example, the earthing device 112 can include a grounding rod, grounding strap, or other conductive element configured to provide a path to an earth or other ground reference. In some embodiments, energy sources, such as the DC source 102 or a grid forming energy source (GFM) 108 (e.g., generator set or utility grid) can include an earthing device 112. The earthing device 112 can be coupled with a neutral line 133 of a wye-connected device (e.g., to provide a low inductance path between the neutral line 133 and a proximal chassis or earth ground).

A first instance 111 of a ground fault can form at a DC domain corresponding to a high side voltage (e.g., +400V). A second instance 113 of a ground fault can form at a DC domain corresponding to a low side voltage (e.g., -400V). For example, the first instance 111 or the second instance can develop in the DC source 102, a DC domain of the inverter 104, or in a connection therebetween.

The earthing transformer 106 can couple the inverter output with a ground reference. The earthing transformer 106 can provide a ground reference at the output of the inverter 104, as in the case of a delta output, to aid in the detection of a ground fault (e.g., according to a voltage decrease at a faulted leg of the delta output). The earthing transformer 106 may be implemented as a zig-zag transformer for creating a neutral without additional impedance, or a delta-wye for establishing a grounded neutral point. The ground reference can be associated with a grid forming energy source (GFM) 108 such as a power generation station of a utility grid or a generator set operating in a GFM mode. For example, the ground reference can correspond to a neutral line 133 of a wye-connected element of the GFM 108. However, the DC source 102, inverter 104, or earthing transformer 106 may be disposed remote from the GFM 108 such that a ground reference may differ between the GFM 108 and other system components.

An output 105 of the inverter 104 can include multiple phases, such as a first phase, second phase and third phase. Any of the phases can develop an electrical path to a ground, termed as a ground fault. For example, the first phase can develop a third instance 115 of a ground fault, the second phase can develop a fourth instance 117 of a ground fault, and the third phase can develop a fifth instance 119 of a ground fault. The controller 110 is configured to classify fault states corresponding to the various ground fault instances, in some embodiments. The fault states can correspond to ground faults of an AC circuit at an output of the inverter (e.g., internal or external to the inverter). For example, the controller 110 can classify a first fault state corresponding to a ground fault between a first phase of the output of the inverter and a ground reference (e.g., the third instance 115). The controller 110 can classify a second fault state corresponding to a ground fault between a second phase of the output of the inverter and the ground reference (e.g., the fourth instance 117). The controller 110 can classify a third fault state corresponding to a ground fault between a third phase of the output of the inverter and the ground reference (e.g., the fifth instance 119). The controller 110 can classify an absence of a fault between any phase of the output of the inverter and the ground reference.

The controller 110 can classify various further fault states related to the inverter 104. For example, the controller 110 can classify a ground fault for the DC source 102. For example, the controller can receive an indication of a voltage at a first direct current (DC) input to the inverter and a at a second DC input to the inverter. In some embodiments, the voltage corresponding to the respective DC inputs are provided as symmetrical to a ground reference (e.g., as +400 volts as referenced to ground for a high side and -400 volts as referenced to ground for a low side). The controller 110 can classify, based on a comparison of the voltages, a fault state of the circuit including the inverter 104. In some embodiment, the system 100 includes the inverter 104, DC source 102, or GFM 108 (e.g., generator set). In some embodiments, the system 100 omits one or more of the inverter 104, DC source 102, or GFM 108, and is configured to couple with the omitted one of the inverter 104, DC source 102, or GFM 108.

The controller 110 can communicate with various components of the system 100. For example, a network including one or more Modbus, controller area network (CAN), local area network (LIN), Ethernet, serial, or other links can couple various system components. The network can include a data link 121 between the DC source 102 and the controller 110. The network can include a data link 123 between the inverter 104 and the controller 110. The network can include a data link 125 between the controller 110 and switches 120 (e.g., circuit breakers, which may be implemented according to various electromechanical or solid-state designs). The network can include a data link 127 between the controller 110 and one or more sensors 130 to receive an indication of a power signal (e.g., a voltage or current). For example, the data link 127 can receive the indication from sensors 130 coupled with the earthing transformer or with the DC source 102.

The controller 110 can, via the various data links, control an operation of the various components. The controller 110 can actuate switches 120 (via data links of the network) based on device statuses (e.g., statuses received via data links of the network). For example, the controller 110 can receive, from the inverter 104, an indication of inverter status and generate, responsive to the receipt of the indication, a control signal to effect a decoupling of the inverter 104 from a power source. The power source can include either of the DC source 102 or the GFM 108. The inverter status can include any of a ground fault or another condition such as a temperature, voltage, line-to-line fault, or so forth. Likewise, the controller 110 can provide control signals to control the DC source 102 (e.g., a disconnect switch thereof), or other system components. In some embodiments, the controller 110 communicates the control signal to the inverter 104 to decouple the inverter from a DC circuit (e.g., a battery or other DC input 102) at an input of the inverter 104.

Upon a detection of a fault state, (e.g., responsive to the detection of the fault state) the controller 110 can generate a control signal to cause a decoupling between the inverter and a grid forming energy source (GFM) 108. The controller can communicate the control signal over one or more links of the network. In some embodiments, the controller 110 communicates the control signal to a circuit breaker or other switch 120, to actuate the switch, to decouple the inverter from an AC circuit at the output 105 of the inverter 104. In some embodiments, the controller 110 communicates the control signal with another system component to cause the other system component to decouple an energy source from the inverter 104, or the inverter 104 from the GFM 108.

In some embodiments the controller 110 can maintain system operation in the presence of some fault states, such as single-ground fault states. For example, for some high-reliability applications (e.g., telecommunications infrastructure), maintaining uptime can outweigh shutting down upon fault detection, even where the fault may damage equipment. For example, the controller 110 can cause a generation of a notification (e.g., via a light emitting diode (LED), SMS message, or log file entry) and continue operation. However, some fault states can include multiple ground faults. For example, multiple ground faults can arise from a same mechanical impact, or over time (e.g., according to an accumulation of dust or abraded insulation). Multiple ground faults can couple with each other, leading to line-to-line faults which may damage system components or otherwise interrupt power delivery (e.g., by triggering protective measures). Accordingly, some systems 100 configured to maintain operation upon detection of a single fault may shut down after detection of multiple faults. That is, in some embodiments, the controller 110 is configured to generate a control signal to effect a decoupling of the inverter from a power source responsive to a detection of multiple faults. In some embodiments, the controller 110 is configured to generate the control signal responsive to a single fault. In some embodiments, the controller 110 may be select-ably configured to effect the decoupling upon a selectable number of ground fault detections (e.g., according to a user interface such as a button, toggle, touchscreen, configuration file, or so forth).

In some embodiments, the controller 110 can interface with multiple inverters 104, DC sources 102, or other components. The controller 110 can detect a fault state for one or more of the inverters. Responsive to the detection, the controller 110 can cause the inverter to be decoupled from an input or output circuit. The controller 110 can effect the decoupling according to a switch external to the inverter 104 (e.g., a circuit breaker or battery disconnect switch), or internal to the inverter (e.g., according to a communication with one or more processors of the inverter via a Modbus or other data link of a network).

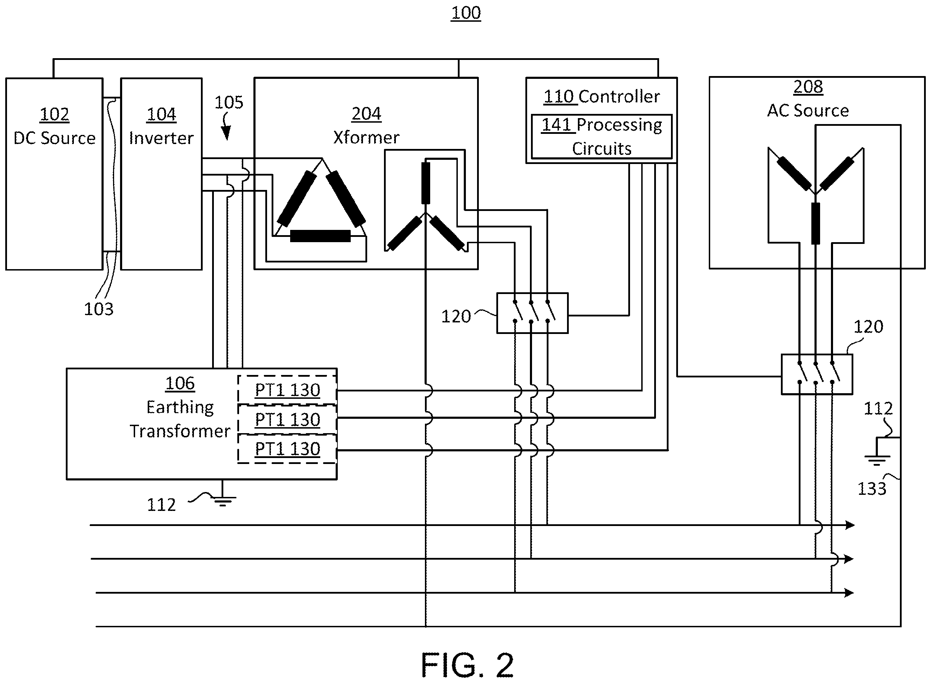

FIG. 2 is a block diagram of an example fault detection system 100 for a power distribution network, according to some embodiments. The fault detection system 100 includes a controller including one or more processing circuits 141 configured to receive, from a sensor 130 coupled with an earthing transformer 106, an indication of a voltage of each of multiple phases of an alternative current (AC) signal of an inverter 104 (depicted as each phase of a three phase output of the inverter 104). The one or more processing circuits 141 are configured to determine a first voltage between two of the phases (e.g., a difference). The one or more processing circuits 141 are configured to determine a presence of a ground fault based on the first voltage (e.g., the difference). The one or more processing circuits 141 are configured to generate a control signal to decouple an energy source (e.g., a DC source 102 or an AC source 208) from the inverter 104 responsive to the presence of the ground fault. In some embodiments, the presence of the ground fault is determined by comparing the first voltage to a predefined threshold. For example, the threshold can be near zero, as in the case of a five- or ten-volt threshold for a 480V system. In some embodiments, the fault detection system 100 includes the earthing transformer 106, sensors 130, and one or more switches to effect the decoupling.

The power distribution network includes an inverter 104 configured to couple with one or more power sources, such as a DC energy source 102 and an AC energy source 208 (e.g., generator set, utility grid, or so forth). For example, the DC energy source can include a battery, fuel cell, photo-voltaic panel, or other inverter input and the AC source 208 can include a grid forming source (GFM) 108. The inverter 104 is galvanically isolated from the AC source 208. A delta-wye transformer 204 is depicted coupling the inverter 104 with the AC source 208, although other energy transfer devices are contemplated.

According to the galvanic isolation, a ground reference of the AC source 208 may not be available for coupling with the inverter. For example, where a ground reference is provided according to a coupling to the neutral line 133 of an AC source 208, as is depicted in FIG. 1, any currents flowing into or out of an earthing device 112 can defeat the galvanic isolation. Accordingly, an earthing device 112 for the earthing transformer 106 can be provided as separate from the neutral line 133 of the AC source 208 and any ground straps or other earthing devices 112 thereof. For example, the earthing transformer 106 and AC source 208 can couple separately to a reference ground (e.g., earth ground). The earth ground or other ground references can vary somewhat along a distance between the AC source 208 and the inverter 104. However, the shared reference can limit deviation from a ground and can provide a ground reference for the controller 110. For example, the controller 110 can detect ground faults at an input of the inverter 104 (e.g., the first instance 111 or second instance 113 as depicted in FIG. 1) or an output of the inverter (e.g., the third instance 115, fourth instance 117, or fifth instance 119) with reference to a ground reference from the earthing device 112 coupled with the earthing transformer 106.

Referring again to the sensor 130, the sensor 130 can include transducers to detect a voltage or current of each of multiple phases of an output 105 of the inverter 107. In some embodiments, the sensor 130 includes a first potential transformer coupled with a first phase of an output 105 of the inverter 107, a second potential transformer coupled with a second phase of the output 105 of the inverter 107, and a third potential transformer coupled with a third phase of the output 105 of the inverter 107. In various embodiments, the transducers can employ various detection principles. For example, in various embodiments, the transducers may be implemented as hall effect sensors 130, electro-optical sensors 130, capacitive voltage sensors 130, Rogowski coils, or potential transformers (e.g., as discussed above).

The controller 110 can receive an indication of an input voltage from a DC input (e.g., the first DC input 103 and the second DC input 103) to the inverter. For example, the controller 110 can receive a voltage or current from another sensor 130 coupled with the inputs of the DC source 102 or at an input to the inverter 104. The controller 110 can compare the DC inputs (e.g., a sum thereof or another processed signal) to a predefined threshold. For example, where the DC inputs are symmetrical to a ground reference, the predefined threshold may be near ground so that the sum of the high side and low side inputs sum to approximately zero in a non-faulted state. In a faulted state, the sum can exceed a positive threshold upon a formation of a ground fault on the low side, and subceed a negative threshold upon a formation of a ground fault on the high side. The controller 110 can interrupt a connection between the inverter and an energy source responsive to the comparison. The interrupted connection can be disposed between the inverter 104 and the DC input (e.g., a battery disconnect of the DC source 102). The interrupted connection can be disposed between the inverter 104 and an AC circuit at an output 105 of the inverter 107 (e.g., the AC source 208).

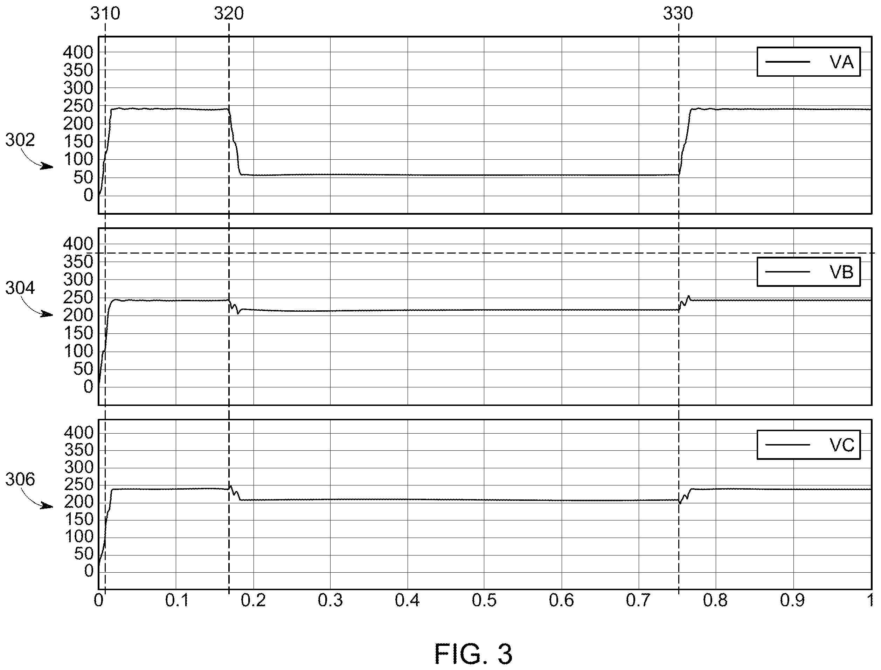

FIG. 3 depicts a voltage of various phases of an inverter output, as referenced to an earthing device 112 coupled with an earthing transformer 106, according to some embodiments. For example, the earthing device 112 can couple with a neutral line 133 of an AC source 208 such as the GFM 108 depicted in FIG. 1, or with another ground reference, such as an earth ground, as depicted in FIG. 2. Particularly, a first waveform 302 (which may be referred to as V_{A}) depicts an output voltage of a first phase of an inverter output 105; a second waveform 304 (which may be referred to as V_{B}) depicts an output voltage of a second phase of the inverter output 105; a third waveform 306 (which may be referred to as Vc) depicts an output voltage of a third phase of the inverter output 105. Each of the first waveform 302, second waveform 304, and third waveform 306 are provided as the average of root-means-squared (RMS) values.

At a first time 310, the outputs can energize. For example, the controller 110 may be in communication with the inverter 104, and control signals can be exchanged therebetween to indicate that the inverter 104 and any other portions of the power distribution network monitored by the controller 110 are in a condition for operation. The inverter 104 can begin operation incident to such communications, providing on-nominal outputs to each phase until the second time.

At the second time, a ground fault develops at the first output phase, as evidenced in the first waveform 302. The first waveform 302 decreases in voltage as reference to the ground reference of the earthing transformer 106. The second output phase and third output phase, as evidenced by respective second 304 and third waveforms 306 exhibit a (lesser) voltage drop due to unbalanced system impedance, increased line current though the non-faulted lines, and other line-line asymmetries owing to the ground fault. A third time 330 indicates a return to normal operation, such as according to technician intervention or a temporary resolution of an intermittent condition (e.g., the ground drying near degraded insulation).

By comparing the nominal voltage to a threshold during operation, the controller 110 can detect a ground fault on one or more phases. Further, the controller 110 can provide an indication of a faulted phase, which may improve resolution times. However, the controller 110 would need to compare an expected voltage of the phases and be aware of bring up or bringdown times, even where network communication or delays may operate non-deterministically. For example, where a ground fault is present at startup, a controller 110 configured to begin monitoring before output phases reach a nominal voltage may indicate a presence of a fault where no fault is present. Conversely, a controller 110 configured to begin monitoring after bring-up can incur delay in ground fault detection. By determining a difference between the phases, and comparing the difference (e.g., the magnitude thereof) to a predefined threshold, the controller 110 can maintain monitoring of the inverter during various operational stages. An example of line-line differences is provided henceforth.

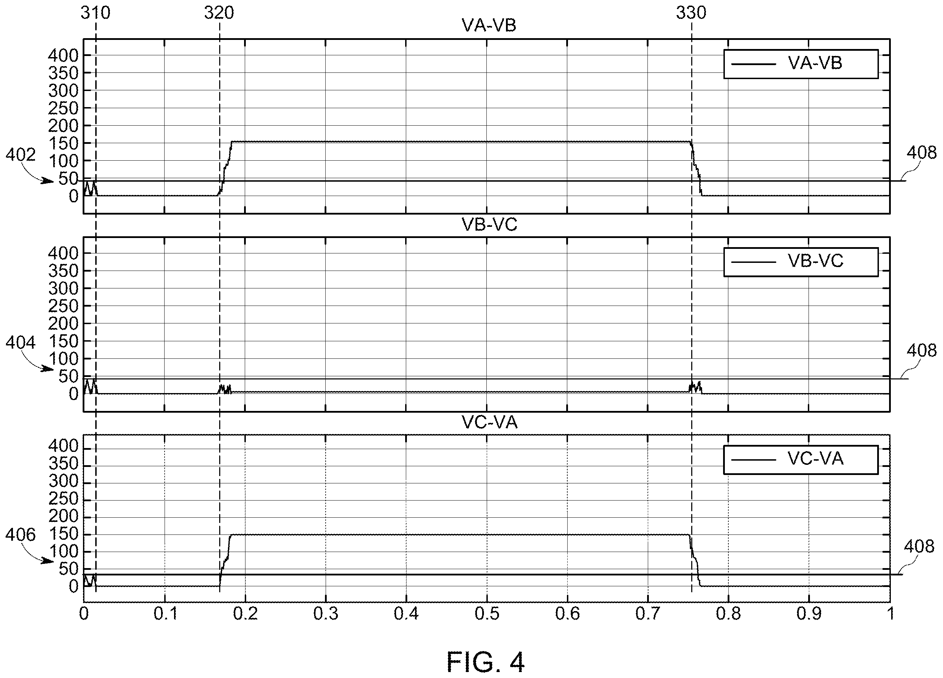

FIG. 4 depicts a difference between the phases of FIG. 4, according to some embodiments. For example, a first of the depicted waveforms 402 depicts a difference between the first waveform 302 and the second waveform 304 of FIG. 3. A second of the depicted waveforms 404 depicts a difference between the second waveform 304 and the third waveform 306 of FIG. 3. A third of the depicted waveforms 406 depicts a difference between the third waveform 306 and the first waveform 302 of FIG. 3. The differences are provided as an absolute value of the difference, such that a single threshold may be compared to the difference. In some embodiments, the differences may be provided as an absolute value or signed value. For example, a separate threshold can be provided for positive or negative values. The separate thresholds can be symmetric about the reference voltage (as in the case of an absolute value), or offset therefrom. For example, the thresholds can be provided as +/- five volts or five volts below the reference and ten volts above the reference.

At the first time 310, each of the outputs evidenced by the depicted first waveform 402, second waveform 404, and third waveform 406 can energize to a nominal voltage. However, according to a concurrent ramp of the various output phases, a difference between the phases may maintain at or about zero. Nonetheless, differences between the phases may show a non-zero difference between channels. For example, an average of the RMS voltage of the outputs can vary based on a trailing period where one phase is active and another is not yet active, such as during a first cycle of operation. A threshold 408 can be selected to exceed such signals and further tolerate nominal signal variance. The average of the RMS value can introduce damping, as the value will reflect a voltage over a previous cycle. In some embodiments, the value may be further damped or otherwise processed (e.g., by a Proportional-Integral-Derivative Controller, a Proportional-Resonant Controller, a Proportional-Integral Controller, Lead-Lag Controller, etc.).

At the second time 320, an output phase corresponding to the second waveform 304 of FIG. 3 develops a ground fault, leading to a reduction in a voltage thereof. Accordingly, the value of the first waveform 402 (V_{A}-V_{B}), exceeds the threshold 408. The absolute value of the third waveform 406 (V_{C}-V_{A}) also exceeds the threshold 408. The value of the second waveform 404 (V_{B}-V_{C}) does not exceed the threshold (e.g., remains at or close to zero). The controller 110 can determine that the fault is located on the first phase, included in the waveforms (402, 406) including V_{A} and not included in the second waveform 404 not including V_{A}. Correspondingly, an absolute value exceeding the threshold 408 for the first waveform 402 and the second waveform 404 can indicate a ground fault on the second phase, V_{B}. An absolute value exceeding the threshold 408 for the second waveform 404 and the third waveform 406 can indicate a ground fault on the third phase, Vc. Even where the non-faulted phases exhibit a reduction in voltage (as depicted in FIG. 4), the difference between the phases can indicate zero, since both non-faulted phases are affected symmetrically. The controller 110 can determine a fault state indicating a lack of ground faults (e.g., a null fault state or normal state) based on none of the values of the first waveform 402, second waveform 404 or third waveform 406 exceeding the threshold 408.

At the third time 330, the fault condition resolves, returning the waveform 402, 404, 406 values to the values exhibited prior to the fault at the second time 320.

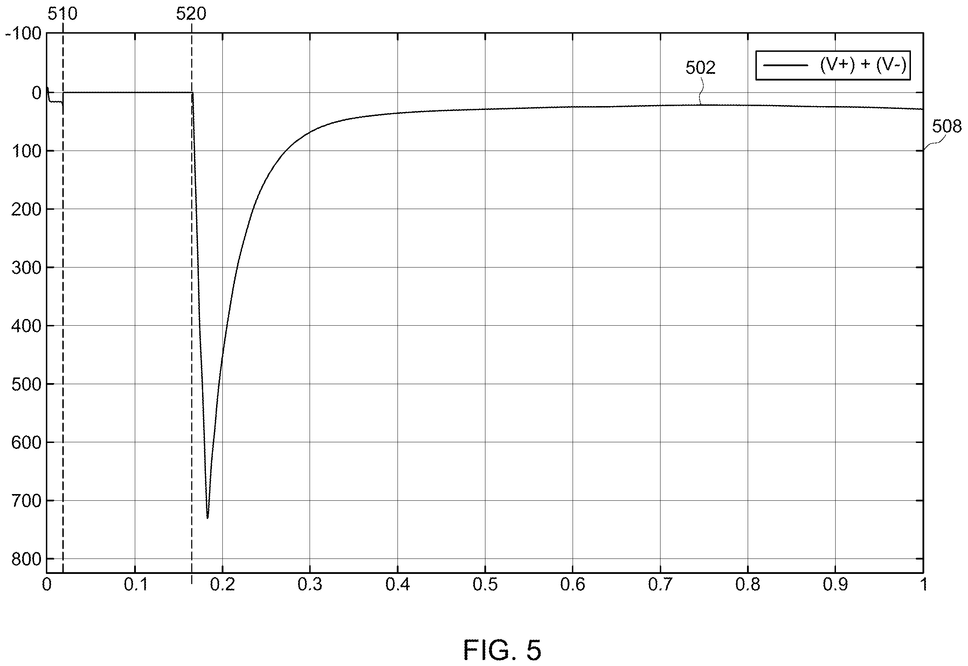

FIG. 5 depicts a sum of first and second DC inputs 103 undergoing a ground fault, according to some embodiments. The first and second DC input 103 can be symmetrical to a reference ground (e.g., a same reference ground of the AC output and earthing transformer 106), such that the sum is equal to zero (or proximal to zero according to nominal fluctuations and measurement error). In some embodiments, the first and second DC input 103 are not symmetrical about ground such that the DC inputs 103 sum to a non-zero value (e.g., zero volts and four-hundred volts for a DC source 102 having a negative terminal at a ground reference voltage).

At a first time 510, a waveform 502 corresponding to the first and second DC input 103 (e.g., a sum thereof) sums to zero, such that the voltage does not exceed a magnitude of a negative side threshold 508. At a second time 520, a ground fault develops on the positive terminal of a DC link between the DC source 102 and the inverter 104. The positive terminal of the DC source 102 drops in value as current flows to the ground, lowering a difference between the positive terminal and ground (e.g., to or near zero in the case of a low-impedance fault). Accordingly, subsequent to the second time 520, the sum of the negative terminal (which is negative) and the positive terminal (which may be positive, but of diminished magnitude), is negative. Conversely, upon a ground fault at the negative terminal, the sum of the voltages can be positive. In either case, the value may exceed a threshold 508 (e.g., a magnitude threshold for an absolute value or separate high-side and low-side thresholds 508).

As indicated above, although the zero-centered symmetrical voltages of the battery can aid in the depiction of the fault, as in FIG. 5, and may reduce computational complexity, the same techniques may be employed for any other values (e.g., a positive or negative terminal can be tied to ground via an earthing device 112 or the DC source 102 can float).

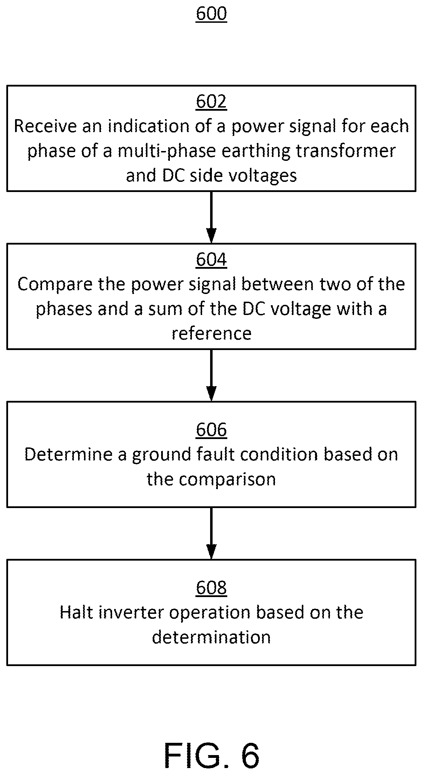

FIG. 6 provides a flow diagram for a method 600 of fault detection, according to some embodiments. The method 600 can be performed by a controller 110, such as a controller 110 as depicted in FIG. 1, FIG. 2, or FIG. 7. In brief summary, the method 600 includes, at operation 602, receiving, from a sensor coupled with a multi-phase earthing transformer, an indication of a power signal for each phase of the multi-phase earthing transformer. The method includes, at operation 604, comparing a magnitude of the power signal between two of the phases. The method includes, at operation 606, determining a ground fault condition based on the comparison. The method includes, at operation 608, halting the operation of an inverter based on the determination.

Referring again to operation 602, the controller 110 receives an indication of a voltage signal for multiple phases (e.g., a voltage of three output terminals corresponding thereto, V_{A}, V_{B}, Vc). The controller 110 can calculates the average of the RMS values of the phases to obtain the steady state value of the voltages. The controller 110 can receive the indication from a sensor 130 coupled with a multi-phase (e.g., three-phase) earthing transformer 106. For example, the sensor can receive the power signal (e.g., voltage) from a potential transformer (PT) coupled with the earthing transformer 106.

Referring again to operation 604, the controller 110 can compare a magnitude of the power signal between two of the phases. Further, the controller 110 can compare a magnitude of the power signal between each of the phases. In some embodiments, the controller 110 computes a difference in voltage between the various phases (e.g., an average of RMS voltage) to compare the power signals to each other. In some embodiments, the controller 110 compares the signals (e.g., a difference therebetween) to a predefined threshold (e.g., an absolute value threshold or a separate high-side and low-side threshold).

Referring again to operation 606, the controller 110 can determine a ground fault condition based on the comparison. For example, where the difference between the phases of the voltages does not exceed the threshold(s) (e.g., is at or near zero), the controller 110 can determine a fault state (or absence thereof, such as a null fault state). For example, where all phases of a three-phase output are zero, the controller 110 can classify the state of the circuit as lacking a ground fault.

Where an absolute value of V_{A}-V_{B} exceeds a threshold (e.g., is non-zero) and V_{C}-V_{A} exceeds a threshold (e.g., is non-zero), the controller 110 can classify the state of a circuit including the inverter as having a ground fault on a first phase, V_{A}. In some embodiments, the controller 110 further bases the determination of the fault state on a difference between V_{B} and Vc, such as a determination that the V_{B} and Vc = 0 or otherwise does not exceed the threshold (and a corresponding determination of a third difference for the examples provided henceforth). Where a value of V_{A}-V_{B} exceeds a threshold (e.g., is non-zero) and an absolute value of V_{B}-V_{C} exceeds a threshold (e.g., is non-zero), and V_{A}-V_{C} is zero, the controller 110 can classify the state of a circuit including the inverter as having a ground fault on a second phase, V_{B}. Where a value of V_{B}-V_{C} exceeds a threshold (e.g., is non-zero) and an absolute value of V_{C}-V_{A} exceeds a threshold (e.g., is non-zero), and V_{A}-V_{B} is zero, the controller 110 can classify the state of a circuit including the inverter as having a ground fault on a third phase, Vc.

In some embodiments, the controller 110 can identify ground faults associated with a DC input to the controller 110. For example, the controller 110 can receive an indication of a power signal (e.g., voltage or current) associated with a DC source 102 for the inverter 104 and determine a ground fault based on a deviation from an expected value. The DC source voltage can be provided from a ground reference which may be a same ground reference as for an earthing transformer 106 coupled with the inverter 104 or another ground reference. Where the DC source voltage is symmetrical to a ground reference, the controller 110 can sum the low-side and high-side voltages and determine a magnitude of a deviation from the ground reference. Where the DC source voltage is not symmetrical to a ground reference, the controller 110 can determine another threshold (e.g., separate positive and negative thresholds which may themselves be symmetrical or asymmetrical with respect to the ground reference).

Referring again to operation 608, the controller 110 halts the operation of an inverter based on the determination of operation 606. In some embodiments, the controller 110 halts the operation by sending to a second controller of the inverter 104, an instruction to halt operation. For example, the controller can convey the halt instruction via Modbus or another data link of the network. In some embodiments, the controller 110 halts the operation by actuating a switch electrically coupled with an isolation transformer (e.g., the delta-wye transformer 204 of FIG. 2). The isolation transformer can include a first winding electrically coupled with an output of the inverter 104 (e.g., the delta-connected side) and a second winding electrically coupled with an AC circuit at the output 105 of the inverter 107 (e.g., the wye-connected side). For example, the isolation transformer can couple the inverter with a GFM 108 or other AC energy source 208.

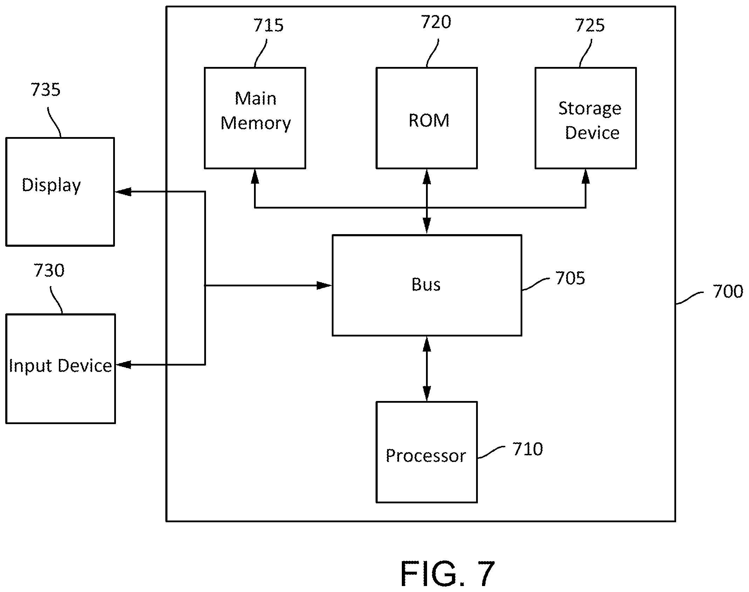

FIG. 7 is a block diagram illustrating an architecture for a computer system that can be employed to implement elements of the systems and methods described and illustrated herein. The computer system or computing device 700 can include or be used to implement a controller 110 or its components, and components of other of the processing circuits 141 (e.g., a second processor of the inverter 104 or other processor implementing a data link). The computing system 700 includes at least one bus 705 or other communication component for communicating information and at least one processor 710 or processing circuit 141 coupled to the bus 705 for processing information. The processing circuits 141 of the computing device 700 can include specific function circuits or general-purpose circuitry (e.g., an ALU) to execute instructions. The computing system 700 can also include one or more processors 710 or processing circuits 141 coupled to the bus for processing information. The computing system 700 also includes at least one main memory 715, such as a random-access memory (RAM) or other dynamic storage device, coupled to the bus 705 for storing information, and instructions to be executed by the processor 710. The main memory 715 can be used for storing information during execution of instructions by the processor 710. The computing system 700 can further include at least one read only memory (ROM) 720 or other static storage device coupled to the bus 705 for storing static information and instructions for the processor 710. A storage device 725, such as a solid-state device, magnetic disk or optical disk, can be coupled to the bus 705 to persistently store information and instructions (e.g., in a data repository).

The computing system 700 can be coupled via the bus 705 to a display 735, such as a liquid crystal display, or active-matrix display. An input device 730, such as a keyboard or mouse can be coupled to the bus 705 for communicating information and commands to the processor 710. The input device 730 can include a touch screen display 735.

The processes, systems and methods described herein can be implemented by the computing system 700 in response to the processor 710 executing an arrangement of instructions contained in main memory 715. Such instructions can be read into main memory 715 from another computer-readable medium, such as the storage device 725. Execution of the arrangement of instructions contained in main memory 715 causes the computing system 700 to perform the illustrative processes described herein. One or more processors in a multi-processing arrangement can also be employed to execute the instructions contained in main memory 715. Hard-wired circuitry can be used in place of or in combination with software instructions together with the systems and methods described herein. Systems and methods described herein are not limited to any specific combination of hardware circuitry and software.

Although an example computing system has been described in FIG. 7, the subject matter including the operations described in this specification can be implemented in other types of digital electronic circuitry, or in computer software, firmware, or hardware, including the structures disclosed in this specification and their structural equivalents, or in combinations of one or more of them.

The disclosure further includes the examples contemplated in the following Clauses:
Clause A1. A power generation system including: an inverter (e.g., the inverter 104).
Clause A2. The power generation system of Clause A1 further including a switch (e.g., the switch 120) to selectively couple an output of the inverter with an AC source.
Clause A3. The power generation system of Clause A2 further including a DC source (e.g., the DC source 102) coupled with the inverter.
Clause A4. The power generation system of any of Clauses A1-A3, further including the AC source (e.g., the AC source 208).
Clause A5. The power generation system of any of clauses A1-A4, wherein the AC source is a grid forming source, such as a generator set.
Clause B1. A system for fault detection for use with an inverter, such as the inverter of Clauses A1-An. The system includes an earthing transformer structured to be coupled with an alternating current (AC) output of the inverter, an earthing device, and a controller. The controller is configured to receive a voltage for each of multiple phases of an output of the inverter. The controller is configured to determine a difference between a first voltage of the voltages and a second voltage of the voltages. The controller is configured to compare the determined difference to a predefined threshold. The controller is configured to classify, based on the comparison, a first fault state of a circuit including the inverter.
Clause B2. The system of Clauses B1, wherein the controller is configured to classify a fault state such as the first fault state, corresponding to a ground fault between a first phase of the output of the inverter and a ground reference, a second fault state corresponds to a ground fault between a second phase of the output of the inverter and the ground reference, a third fault state corresponds to a ground fault between a third phase of the output of the inverter and the ground reference, or an absence of a fault between a phase of the output of the inverter and the ground reference.
Clause B3. The system of Clauses B1 or B2, wherein the controller is configured to receive an indication of a third voltage at a first direct current (DC) input to the inverter, receive an indication of a fourth voltage at a second DC input to the inverter, and classify, based on a comparison of the third voltage to the fourth voltage, a second fault state of the circuit comprising the inverter.
Clause B4. The system of any of Clauses B1-B3 wherein the controller is configured to generate a control signal responsive to the detection of a fault state, the control signal to cause a decoupling between the inverter and a grid forming energy source.
Clause B5. The system of any of Clauses B1-B4 wherein the controller is configured to generate the control signal responsive to multiple detected faults.
Clause B6. The system of Clause B4, wherein the controller is configured to generate the control signal responsive to a single fault.
Clause B7. The system of any of Clauses B1-B6 wherein the controller is configured to detect the first fault state for each of a plurality of inverters.
Clause B8. The system of any of Clauses B1-B7 wherein the controller is configured to receive, from the inverter, an indication of an inverter status, and generate, responsive to the receipt of the indication, a control signal to effect a decoupling of the inverter from a power source.
Clause B9. The system of any of Clauses B1-B8 wherein the controller is configured to communicate the control signal to a switch to actuate the switch to decouple the inverter from an AC circuit at the output of the inverter.
Clause B10. The system of any of Clauses B1-B9 wherein the controller is configured to communicate the control signal to the inverter to decouple the inverter from a DC circuit at an input of the inverter.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

As utilized herein, the terms "approximately," "about," "substantially," and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed are considered to be within the scope of the disclosure as recited in the appended claims.

It should be noted that the term "exemplary" and variations thereof, as used herein to describe various embodiments, are intended to indicate that such embodiments are possible examples, representations, or illustrations of possible embodiments (and such terms are not intended to connote that such embodiments are necessarily extraordinary or superlative examples).

The term "coupled" and variations thereof, as used herein, means the joining of two members directly or indirectly to one another. Such joining can be stationary (e.g., permanent or fixed) or moveable (e.g., removable or releasable). Such joining can be achieved with the two members coupled directly to each other, with the two members coupled with each other using one or more separate intervening members, or with the two members coupled with each other using an intervening member that is integrally formed as a single unitary body with one of the two members. If "coupled" or variations thereof are modified by an additional term (e.g., directly coupled), the generic definition of "coupled" provided above is modified by the plain language meaning of the additional term (e.g., "directly coupled" means the joining of two members without any separate intervening member), resulting in a narrower definition than the generic definition of "coupled" provided above. Such coupling can be mechanical, electrical, or fluidic. For example, circuit A communicably "coupled" to circuit B can signify that the circuit A communicates directly with circuit B (i.e., no intermediary) or communicates indirectly with circuit B (e.g., through one or more intermediaries).

References herein to the positions of elements (e.g., "top," "bottom," "above," "below") are merely used to describe the orientation of various elements in the FIGURES. It should be noted that the orientation of various elements can differ according to other exemplary embodiments, and that such variations are intended to be encompassed by the present disclosure. The term "or," as used herein, is used in its inclusive sense (and not in its exclusive sense) so that when used to connect a list of elements, the term "or" means one, some, or all of the elements in the list.

Although the figures and description may illustrate a specific order of method steps, the order of such steps may differ from what is depicted and described, unless specified differently above. Also, two or more steps may be performed concurrently or with partial concurrence, unless specified differently above. Such variation may depend, for example, on the software and hardware systems chosen and on designer choice. All such variations are within the scope of the disclosure. Likewise, software implementations of the described methods could be accomplished with standard programming techniques with rule-based logic and other logic to accomplish the various connection steps, processing steps, comparison steps, and decision steps.

It is important to note that the construction and arrangement of the systems and methods as shown in the various exemplary embodiments is illustrative only. Additionally, any element disclosed in one embodiment may be incorporated or utilized with any other embodiment disclosed herein. Although only one example of an element from one embodiment that can be incorporated or utilized in another embodiment has been described above, it should be appreciated that other elements of the various embodiments may be incorporated or utilized with any of the other embodiments disclosed herein.

## Claims

1. A system for fault detection, the system comprising:
an earthing transformer (106) structured to be coupled with:
an alternating current (AC) output of an inverter (104); and
an earthing device (112); and
a controller (110) configured to:
receive a voltage for each of a plurality of phases of an output of the inverter;
determine a difference between a first voltage of the plurality of voltages and a second voltage of the plurality of voltages;
compare the determined difference to a predefined threshold; and
classify, based on the comparison, a first fault state of a circuit comprising the inverter.

2. The system of claim 1, wherein the controller is configured to classify:
the first fault state corresponding to a ground fault between a first phase of the output of the inverter and a ground reference;
a second fault state corresponding to a ground fault between a second phase of the output of the inverter and the ground reference;
a third fault state corresponding to a ground fault between a third phase of the output of the inverter and the ground reference; and
an absence of a fault between a phase of the output of the inverter and the ground reference.

3. The system of claim 1 or 2, wherein the controller is configured to:
receive an indication of a third voltage at a first direct current (DC) input to the inverter;
receive an indication of a fourth voltage at a second DC input to the inverter; and
classify, based on a comparison of the third voltage to the fourth voltage, a second fault state of the circuit comprising the inverter.

4. The system of any of the preceding claims, wherein the controller is configured to:
generate a control signal responsive to the detection of a fault state, the control signal to cause a decoupling between the inverter and a grid forming energy source.

5. The system of claim 4, wherein the controller is configured to:
generate the control signal responsive to a plurality of faults, or generate the control signal responsive to a single fault.

6. The system of any of the preceding claims, wherein the controller is configured to:
detect the first fault state for each of a plurality of inverters.

7. The system of any of the preceding claims, wherein the controller is configured to:
receive, from the inverter, an indication of an inverter status; and
generate, responsive to the receipt of the indication, a control signal to effect a decoupling of the inverter from a power source.

8. The system of claim 7, wherein the controller is configured to:
communicate the control signal to a switch to actuate the switch to decouple the inverter from an AC circuit at the output of the inverter; and/or
communicate the control signal to the inverter to decouple the inverter from a DC circuit at an input of the inverter.

9. A controller (110) for fault detection, the controller comprising one or more processing circuits configured to:
receive, from a sensor coupled with an earthing transformer (106), an indication of a voltage of each of a plurality of phases of an alternating current (AC) signal of an inverter (104);
determine a first voltage between two of the plurality of phases;
determine a presence of a ground fault based on the first voltage; and
generate a control signal to decouple an energy source from the inverter responsive to the presence of the ground fault.

10. The controller of claim 9, wherein:
the presence of the ground fault is determined by comparing the first voltage to a predefined threshold.

11. The controller of claim 9 or 10, wherein:
the sensor comprises:
a first potential transformer coupled with a first phase of an output of the inverter;
a second potential transformer coupled with a second phase of the output of the inverter; and
a third potential transformer coupled with a third phase of the output of the inverter; and
the controller is configured to:
receive a plurality of signals from at least two of the first potential transformer, the second potential transformer, and the third potential transformer; and
determine the first voltage based on the plurality of signals.

12. The controller of any of claims 9 to 11, wherein the controller is configured to:
receive, from a direct current (DC) input to the inverter, an indication of an input voltage;
compare the DC input to a predefined threshold; and
interrupt a connection, responsive to the comparison, between:
the DC input and the inverter; or
the inverter and an AC circuit at an output of the inverter,
and optionally wherein:
the input voltage is received from a battery having an anode voltage exceeding a ground voltage by a first magnitude, the ground voltage exceeding a cathode voltage by the first magnitude; and
the controller is configured to compare the DC input by summing the cathode voltage and the anode voltage and comparing a magnitude of the summation to a predefined threshold voltage.

13. The controller of any of claims 9 to 12, wherein the controller is configured to:
receive, from the inverter, an indication of inverter status; and
couple, responsive to the indication of inverter status, the inverter with an AC circuit at an output of the inverter.

14. A method for fault detection comprising:
receiving, from a sensor coupled with a multi-phase earthing transformer (106) and by a controller (110), an indication of a power signal for each phase of the multi-phase earthing transformer;
comparing, by the controller, a magnitude of the power signal between two of the phases;
determining, by the controller, a ground fault condition based on the comparison; and
halting, by the controller, operation of an inverter (104) based on the determination.

15. The method of claim 14, wherein:
the method comprises receiving, from a potential transformer, the power signal; and/or
halting the operation comprises sending, by the controller to a second controller of the inverter, an instruction to halt operation; and/or
halting the operation comprises actuating, by the controller, a switch electrically coupled with an isolation transformer having a first winding electrically coupled with an output of the inverter and a second winding electrically coupled with an AC circuit at the output of the inverter.
